# EUROPEAN PATENT SPECIFICATION

(11) **EP 0 329 401 B1**
(45) Date of publication and mention of the grant of the patent: **19.04.1995**
(21) Application number: 89301424.1
(22) Date of filing: 15.02.1989
(51) Int. Cl.: H01L 29/72, H01L 21/22, H01L 29/10

(54) **Bipolar transistors and methods of production**
Bipolartransistor und Verfahren für seine Herstellung
Transistors bipolaires et procédé de fabrication

(30) Priority: 16.02.1988 JP 33686/88
(43) Date of publication of application: 23.08.1989
(73) Proprietor: SONY CORPORATION, Tokyo 141 (JP)
(72) Inventor: Gomi, Takayuki c/o Patents Division, Shinagawa-ku Tokyo 141 (JP)
(74) Representative: Pilch, Adam John Michael

(56) References cited:
- EP-A- 0 096 155
- EP-A- 0 231 811
- EP-A- 0 251 927
- PATENT ABSTRACTS OF JAPAN, vol. 11, no. 190 (E-517)[2637], 18th June 1987; & JP-A-62 18 763
- PATENT ABSTRACTS OF JAPAN, vol. 10, no. 117 (E-400)[2174], 2nd May 1986; & JP-A-60 251 664

## Description

This invention relates to bipolar transistors and to methods of their production.

In order to achieve a high speed and high performance bipolar transistor, it is necessary that the base width WB be narrow and the base resistance Rbb' be of a relatively low value.

For the realisation of high performance bipolar transistors, a technique has been proposed involving forming a link impurity diffusion region between an intrinsic base region forming an active region and a graft base region formed by diffusing impurities from the base contact electrode. This technique is disclosed, for example, in Japanese Patent Applications Nos. 62-184 898, 62-188 025 and 62-188 026.

However, in the previously-proposed technique of linking the intrinsic base region and the graft base region by the link impurity diffusion region, damage may be caused at the time of ion implanting to form the link impurity diffusion region. This damage caused by ion implantation promotes accelerated diffusion in the active region or produces adverse effects by channelling tail. The result is that the base depth may be increased depending on the subsequent annealing.

The aforementioned Japanese Patent Application No. 62-184 898 discloses a method of producing a bipolar transistor wherein a sidewall is formed on the lateral side of the base contact electrode and a substrate portion is removed by taking advantage of this sidewall to form small base and emitter regions. However, the adverse effect of side injection of the emitter and the base becomes predominant such as to interfere with the high speed operation of the transistor.

The disclosure of EP-A- 255882 is to be considered as comprised in the state of the art in accordance with Art. 54(3) insofar as the same Contracting States are designated. Japanese Patent Application no. 60-251 664 discloses a bipolar transistor formed by a method the features of which are similar to the precharacterising part of claim 1.

According to this invention there is provided a method of producing a bipolar transistor, the method comprising the steps of:
selectively forming a device isolation region on the surface of a semiconductor substrate of a first conductivity type;
forming a base contact electrode layer covered by an insulating film extending over a region of the surface of the semiconductor substrate and surrounded at least by the device isolation region;
introducing, using the base contact electrode layer as a portion of a mask, impurities of a second conductivity type through an opening in the insulating film and base contact electrode layer, for forming a link impurity diffusion layer on the surface of said semiconductor substrate;
introducing through the opening in the insulating film and base contact electrode layer impurities of the first conductivity type for forming a diffusion suppression region at the bottom of a region in which a base region is to be formed;
forming a graft base region on the surface of said semiconductor substrate by diffusion of impurities of the second conductivity type from the base contact electrode layer;
forming an intrinsic base region contiguous to said link impurity diffusion region on the surface of said semiconductor substrate; and
forming an emitter region in said intrinsic base region;
characterising in that a buffer film is formed over the opening in the base contact electrode layer, the impurities for forming the link impurity diffusion layer and the diffusion suppression region being introduced through the buffer film, and in that the intrinsic base region and the emitter region are formed by diffusing impurities from a polysilicon layer through the opening in the insulating film covering the base contact electrode layer, the polysilicon layer being formed on a sidewall formed on the lateral side of the opening in the base contact electrode layer and insulating film.

A preferred embodiment of the present invention, to be described in greater detail hereinafter, provides a method of producing a bipolar transistor, wherein the depth of the base to collector junction is made shallow to realise the high performance of the device, despite the fact that the link impurity diffusion region is formed for linking the intrinsic base region and the graft base region.

According to the preferred embodiment, a device isolation region is selectively formed on a semiconductor substrate in the form of a flat plate. The base region formed on the surface of a region surrounded by the device isolation region of the semiconductor substrate is made up of a graft base region formed by diffusion from the base contact electrode, an intrinsic base region acting as the active region and a link impurity diffusion region for linking these regions. The emitter region is formed in the intrinsic base region. A diffusion suppression region is formed in the vicinity of the junction between the base region and the portion of the semiconductor substrate serving as the collector. This diffusion suppression region has a conductivity type opposite to that of the base region.

The graft base region is formed by diffusion of impurities from the base contact electrode layer extended to the region of the semiconductor substrate which is surrounded by the device isolation region, and the emitter region is formed in the intrinsic base region. The intrinsic base region and the emitter region are formed by diffusing impurities from a polysilicon layer through an opening in the base contact electrode layer and in an insulating film covering the base contact electrode layer. The polysilicon layer is formed on a side wall formed on the lateral side of the opening. The method includes the steps of introducing impurities of a second conductivity type to form the link impurity diffusion region so as to be contiguous to the graft base region and the intrinsic base region, and introducing impurities of the first conductivity type in the vicinity of the bottom of the link impurity diffusion region to form the diffusion suppression region. The impurities for forming the link impurity diffusion region and the diffusion suppression region are introduced through a buffer film formed over the opening in the base contact electrode layer.

The invention will now be described by way of example with reference to the accompanying drawings, throughout which like parts are referred to by like references, and in which:
Figure 1 is a sectional view showing a bipolar transistor according to an embodiment of the present invention;
Figure 2 is an enlarged sectional view of part of the transistor shown in Figure 1;
Figure 3 is a chart showing the distribution of the concentration of impurities on a section taken along a line III - III in Figure 2;
Figure 4 is a chart showing the distribution of the concentration of impurities on a section taken along a line IV - IV in Figure 2;
Figure 5 is a chart showing the distribution of the concentration of impurities on a section taken along a line V - V in Figure 2; and
Figures 6a to 6d are sectional views illustrating the various steps of a method of producing a bipolar transistor embodying the present invention.

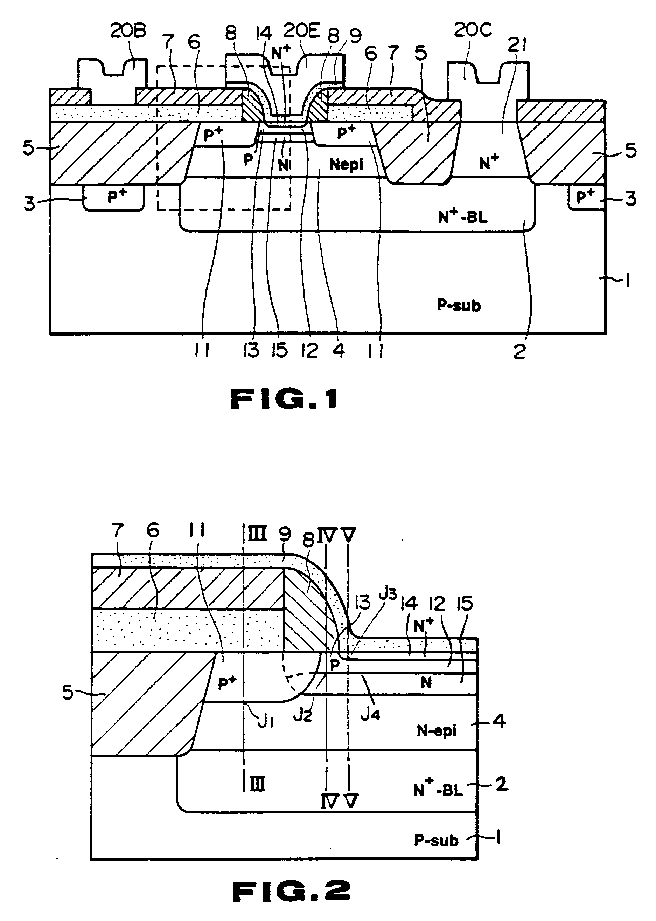

Figure 1 shows the general construction of a bipolar NPN transistor according to an embodiment of the present invention. On a P type silicon substrate 1, there are formed an N⁺ type buried layer 2 and a P⁺ channel stopper layer 3, on the top of which is deposited an N type epitaxial layer 4. A field oxide film 5 is formed on the N type epitaxial layer 4 for device isolation. A portion of the upper part of the epitaxial layer 4 surrounded by the field oxide film 5 is confronted by a polysilicon layer 6 covered by an interlayer insulating film 7. This polysilicon layer 6 contains impurities and is used as the base contact electrode. The polysilicon layer 6 also serves as the source of diffusion of impurities for a graft base region 11 formed within the epitaxial layer 4. The polysilicon layer 6 on the epitaxial layer 4 partially forms an opening. A sidewall 8 formed when etching back the oxide film 5 formed in turn by chemical vapour deposition (CVD) exists on the lateral side of the opening. On the upper surface of the epitaxial layer 4 and the sidewall 8 is deposited a thin polysilicon layer 9, on the top of which is formed an emitter electrode 20E.

The portion of the epitaxial layer 4 adjacent which the opening is formed will now be described, referring to Figure 2. The graft base region 11, which is a P⁺ type impurity diffusion region, is formed by diffusion from the surface of the polysilicon layer 6 contacting the epitaxial layer 4. This graft base region 11 connects to an intrinsic base region 12 which is a P type impurity diffusion region, via a link impurity diffusion region 13, which again is a P type impurity diffusion region. The link impurity diffusion region 13 is formed along the external planar surface of the epitaxial layer 4 from the vicinity of the end of the polysilicon layer 6 and is overlappingly connected to the graft base region 11 at a position below the sidewall 8. The intrinsic base region 12 is formed by diffusion of impurities from the thin polysilicon layer 9 formed on the external planar surface and on the sidewall 8, and is overlappingly connected at the active region with the link impurity diffusion region 13. An emitter layer 14, which is an N⁺ type semiconductor region, is formed on the portion of the epitaxial layer 4 lying on top of the intrinsic base region 12 at the lower side of the polysilicon layer 9. This emitter region 14 is formed, for example, by diffusion of impurities from the polysilicon layer 9. At the lower side of the link impurity diffusion region 13 is formed a diffusion suppression region 15 for suppressing the increase in the depth of the junction of the link impurity diffusion region 13. That is, due to the presence of the diffusion suppression region 15 formed in the vicinity of the junction between the link impurity diffusion region 13 and the N type epitaxial region 4 by introduction of the N type impurities, the junction of the link impurity diffusion region 13, which is the diffusion region of the P type impurities, can be maintained at a shallow depth.

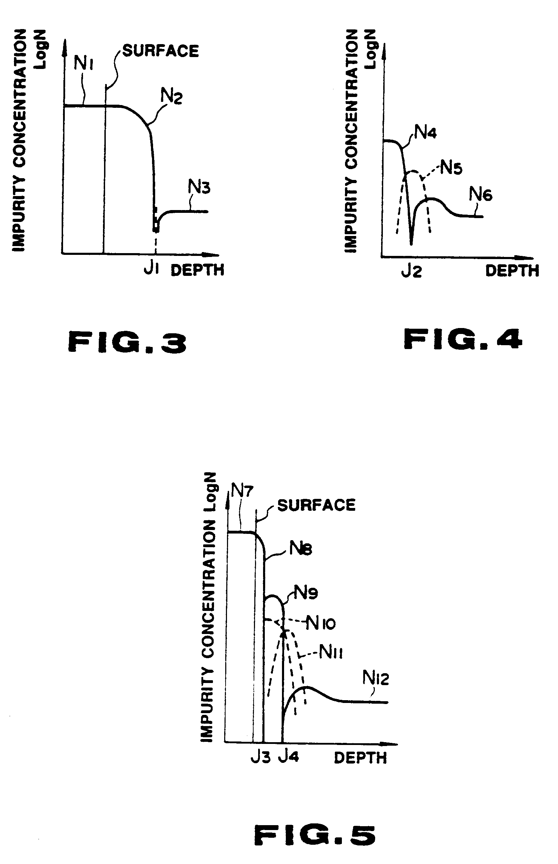

Figures 3, 4 and 5 show the distribution of the concentration of the impurities on the sections taken along lines III - III, IV - IV and V - V in Figure 2. The ordinate represents the concentration of the impurities expressed by a logarithmic scale and the abscissa represents the depth.

Figure 3 shows the impurity concentration on the section along the line III - III. The distribution of the concentration of impurities above the surface of the epitaxial layer 4 is the concentration of the impurities N1 of the polysilicon layer 6. Since the graft base region 11 is formed by diffusion of impurities from the polysilicon layer 6, the impurity region N2 concentration is equal to that of N1 in the vicinity of the surface, and the concentration of the impurities N2 is lowered gradually as the junction J1 is approached. From the junction J1 on, the concentration is equal to the concentration of impurities N3 of the N type epitaxial layer 4.

Figure 4 shows the impurity concentration on the section along the line IV - IV. The impurity diffusion region 13 extends from the surface of the epitaxial layer 4, with the concentration of the impurities N4 decreasing gradually towards the junction J2. The subjacent region of the surface is the epitaxial layer 4 where the distribution of the concentration of the N type impurities N6 prevails. The impurities are introduced in the vicinity of the junction J2 to a concentration of impurities N5 for forming the diffusion suppression region 15. Thus the depth of the junction J2 need not be increased by, for example, thermal processing.

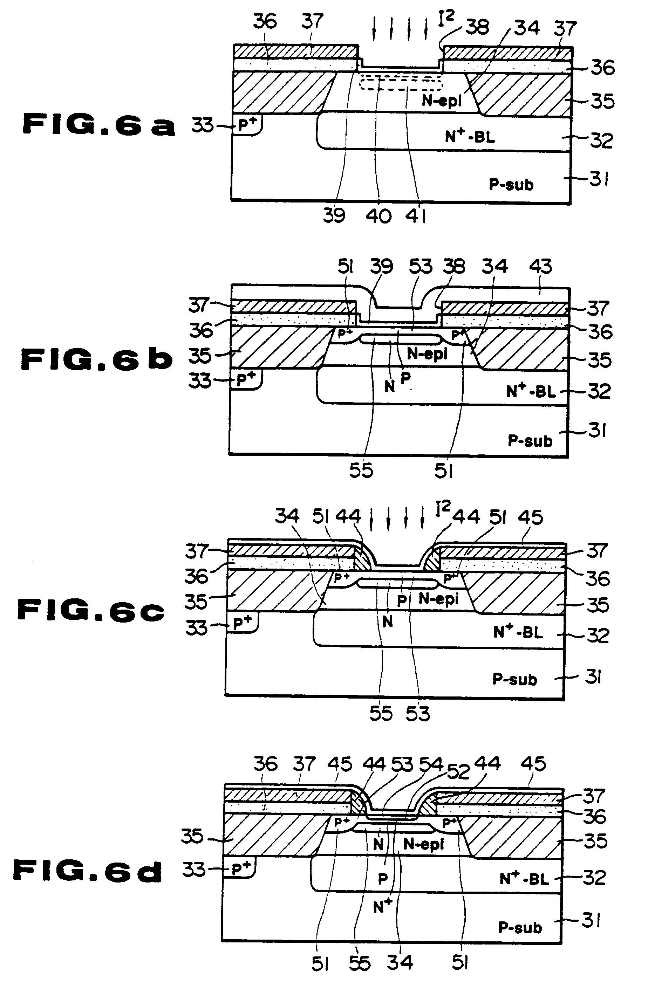

Figure 5 shows the impurity concentration on the section along the line V - V. The distribution of the impurities above the surface of the epitaxial layer 4 is the concentration of impurities N7 of the polysilicon layer 9 of reduced thickness. The emitter region 14 directly below the surface has a comparable concentration of impurities N8 which gradually decreases towards the junction J3. The distribution of impurities N9 of the intrinsic base region 12 prevails from the junction J3 to the junction J4. From the lower side of the junction J4 of the intrinsic base region 12, the distribution of the concentration of the impurities N12 of the epitaxial layer 4 prevails. On the section along the line V - V, as shown by the broken lines therein, there exist the distribution of the concentration of impurities N10 of the link impurity diffusion region 13 (corresponding to the concentration of impurities N4 shown in Figure 4) and the distribution of the concentration of the impurities N11 for producing the diffusion suppression region 15 (corresponding to the concentration of impurities N5 in Figure 4). In this manner, connection to the intrinsic base region 12 can be realised positively through the link impurity diffusion region 13. By virtue of the function of the concentration of impurities N11, it is possible to improve the bipolar transistor without the disadvantage caused by the depth of the junction J4 increasing.

In the above-described bipolar transistor, the base width WB need not be increased. The operation speed of the device can be increased as the depth of junction J4 can be prevented from increasing owing to the function of the diffusion suppression region 15. Inasmuch as the depth of junction can be made shallow, it is not necessary to remove the surface of the epitaxial layer 4 to provide the emitter and base regions. Thus it becomes possible to suppress the effects of side injection.

In addition, the Kirk effect can be suppressed by the fact that the concentration N5 of impurities introduced for forming the diffusion suppression region 15 is set so as to be higher than the concentration of impurities of the N type epitaxial layer 4. The low consumption type bipolar transistor and the high speed bipolar transistor can be selectively prepared by controlling the concentrations of impurities N5 and N11.

It is to be noted that the buried layer 2 in Figure 1 is contiguous to the collector electrode 20C via the collector region 21. The polysilicon layer 6 forming the base contact electrode is contiguous to the base electrode 20B provided via a portion of the interlayer insulating film 7.

The present invention can be applied to PNP transistors as well as to the NPN transistor of the above-described embodiment.

A method of producing the bipolar transistor will now be described with reference to the process steps shown in Figures 6a to 6d.

Referring to Figure 6a, an epitaxial layer 34 is deposited on a P type silicon substrate 31 on which an N⁺ type buried layer 32 and a channel stopper region 33 have previously been formed, and a field oxide film 35, acting as the region for device isolation, is formed on the epitaxial layer 34 by a selective oxidation process. On the top of the epitaxial layer 34, surrounded by the field oxide film 35, there is formed a polysilicon layer 36 which is selectively formed facing the external planar surface of the epitaxial layer 34; the polysilicon layer 36 partially forms an opening 38 and is covered by the interlayer insulating film 37. A thin oxide film 39 acting as a buffer film is formed at the opening 38.

After the oxide film 39 is formed in this manner, ion implantation is performed for forming a link to the impurity diffusion region. A dopant such as B⁺ or BF₂⁺ is used for this ion implantation. Ion implant into a region 40 in the vicinity of the external planar surface of the epitaxial layer 34 is performed in such a way as to avoid the increase in the depth of the base region. It is to be noted that impurities are not introduced into the region below the region of the polysilicon layer 36 in order that the layer 36 may act as the mask.

From the same opening 38, ion implantation is carried out for forming the diffusion suppression region through the oxide film 39. This ion implantation is performed using impurities such as P⁺ in such a manner that the impurities are doped into a deeper region 41 than in the case of the ion implantation aimed at forming the link impurity diffusion region. The Kirk effect can be suppressed by positively increasing the concentration of impurities involved in the ion implantation. The low power consumption type bipolar transistor and the high speed type bipolar transistor can be selectively produced by controlling the concentration of impurities involved in ion implantation.

As shown in Figure 6b, a thick oxide film 43 is then formed on the overall surface by, for example, a chemical vapour deposition method. The opening 38 provided with the thin oxide film 39 at its bottom is also covered by the thick oxide film 43.

A thermal treatment is then performed for diffusing impurities from the polysilicon layer 36 acting as the base contact electrode to form a graft base region 51. The impurities doped into the region 40 are thermally treated to form a link impurity diffusion region 53 in the vicinity of the external planar surface of the epitaxial layer 34 at the bottom of the opening 38. The impurities in the region 41 are also activated to form a diffusion suppression region 55 in the vicinity of the junction with the link impurity diffusion region 53.

The thick oxide film 43, which previously acted as the anneal cap, is now etched back, as shown in Figure 6c, and caused to remain on the side of the opening 38 as a sidewall portion 44. At this time, the oxide film 39 within the opening 38 is also removed.

A thin polysilicon layer 45 is formed on the overall surface. This polysilicon layer 45 extends from the upper surface of the interlayer insulating film 37 to cover the sidewall portion 44, and from the sidewall portion 44 to cover the exterior planar surface on which the link impurity diffusion layer 53 is formed.

Then, as further shown in Figure 6c, ion implantation is performed on the overall surface. By this ion implantation, impurities are introduced into the thin polysilicon layer 45. The introduced impurities are B⁺ or BF₂⁺, for example, and an intrinsic base region 52 is formed by these impurities in the planar surface of the epitaxial layer 34 so as to be contiguous to the link impurity diffusion region 53. It is to be noted that the sidewall portion 44 may act as the mask for the ion implantation and the diffusion of impurities.

Annealing is then performed for forming the intrinsic base region 52. It is to be noted that the intrinsic base region 52 is formed by diffusion of impurities from the polysilicon layer 45 and there is no adverse effect caused by ion implantation, such as channelling tail. The region in which the intrinsic base region 52 is formed is overlapped with the link impurity diffusion region 53, and the diffusion suppression region 55 is formed on the lower portion of the link impurity diffusion layer 53, so that the base width WB of the intrinsic base region 52 may be reduced.

Ion implantation is again performed into the polysilicon layer 45. The impurities involved in this ion implantation may be As⁺, for example, and the emitter region 54 is formed by diffusion of these impurities from the polysilicon layer 45 by thermal treatment. The bipolar transistor shown in Figure 6d is thereby obtained.

A bipolar transistor having the above-described diffusion suppression region 55 may be obtained by the above-described process steps. In such a bipolar transistor, a low base resistance Rbb′ is realised by the link impurity diffusion region 53, while avoiding adverse effects such as deterioration in voltage withstanding properties of the emitter to base resistance Rbb′ or V_{BE} matching properties or lowering in f_{T}. Also, by virtue of the diffusion suppression region 55, increase in the base width WB can be prevented. In addition, by controlling the concentration of the impurities, it is possible to suppress the Kirk effect, or to produce low power consumption type or high speed type devices.

It is to be noted that the above process for the preparation of NPN type bipolar transistors may similarly be applied to the preparation of PNP bipolar transistors.

## Claims

1. A method of producing a bipolar transistor, the method comprising the steps of:
selectively forming a device isolation region (35) on the surface of a semiconductor substrate (31, 32, 34) of a first conductivity type;
forming a base contact electrode layer (36) covered by an insulating film (37) extending over a region of the surface of the semiconductor substrate (31, 32, 34) and surrounded at least by the device isolation region (35);
introducing, using the base contact electrode layer (36) as a portion of a mask, impurities of a second conductivity type through an opening in the insulating film (37) and base contact electrode layer (36), for forming a link impurity diffusion layer (53) on the surface of said semiconductor substrate (31, 32, 34);
introducing through the opening in the insulating film (37) and base contact electrode layer (36) impurities of the first conductivity type for forming a diffusion suppression region (55) at the bottom of a region in which a base region is to be formed;
forming a graft base region (51) on the surface of said semiconductor substrate (31, 32, 34) by diffusion of impurities of the second conductivity type from the base contact electrode layer (36);
forming an intrinsic base region (52) contiguous to said link impurity diffusion region (53) on the surface of said semiconductor substrate (31, 32, 34); and
forming an emitter region (54) in said intrinsic base region (52);
characterised in that a buffer film (39) is formed over the opening in the base contact electrode layer (36), the impurities for forming the link impurity diffusion layer (53) and the diffusion suppression region (55) being introduced through the buffer film (39), and in that the intrinsic base region (52) and the emitter region (54) are formed by diffusing impurities from a polysilicon layer (45) through the opening in the insulating film (37) covering the base contact electrode layer (36), the polysilicon layer (45) being formed on a sidewall (44) formed on the lateral side of the opening in the base contact electrode layer (36) and insulating film (37).

2. A method as claimed in claim 1, wherein the semiconductor substrate (31, 32, 34) of the first conductivity type is formed by providing a buried layer (32) of the first conductivity type on a silicon substrate (31) of the second conductivity type and an epitaxial layer (34) of the first conductivity type is formed on the buried layer (32).

3. A method as claimed in claim 2, whereby the depth of junction between the intrinsic base region (52) and the epitaxial layer (34) has a peak of concentration of impurities in the diffusion suppression region (55).

## Patentansprüche

1. Verfahren zur Herstellung eines bipolaren Transistors, wobei das Verfahren die folgenden Schritte aufweist:
selektives Bilden einer Bauteil-Isolationszone (35) auf der Oberfläche eines Halbleitersubstrats (31, 32, 34) eines ersten Leitfähigkeits-Typus;
Bilden einer Basiskontaktelektrodenschicht (36), die durch eine Isolierschicht 37 bedeckt ist, die sich über eine Zone der Oberfläche des Halbleitersubstrats (31, 32, 34) ausdehnt und zumindest durch die Bauteil-Isolationszone (35) umgeben ist;
Einleiten, wobei die Basiskontaktelektrodenschicht (36) als Teil einer Maske verwendet wird, von Verunreinigungen eines zweiten Leitfähigkeits-Typus über eine Öffnung in der Isolierschicht (37) und der Basiskontaktelektrodenschicht (36), um eine Verbindungsverunreinigungs-Diffusionsschicht (53) auf der Oberfläche des Halbleitersubstrats (31, 32, 34) zu bilden;
Einleiten von Verunreinigungen des ersten Leitfähigkeits-Typus über die Öffnung in der Isolationsschicht (37) und der Basiskontaktelektrodenschicht (36), um eine Diffusionsunterdrückungszone (55) am Boden einer Zone zu bilden, in welcher eine Basiszone gebildet werden soll;
Bilden einer Impfbasiszone (51) auf der Oberfläche des Halbleitersubstrats (31, 32, 34) durch Diffusion von Verunreinigungen des zweiten Leitfähigkeits-Typus von der Basiskontaktelektrodenschicht (36);
Bilden einer i-Basiszone (52), die der Verbindungsverunreinigungs-Diffusionszone (53) benachbart ist, auf der Oberfläche des Halbleitersubstrats (31, 32, 34); und
Bilden einer Emitterzone (54) in der i-Basiszone (52);
dadurch gekennzeichnet, daß eine Pufferschicht (39) über der Öffnung in der Basiskontaktelektrodenschicht (36) gebildet wird, wobei die Verunreinigungen zum Bilden der Verbindungsverunreinigungs-Diffusionsschicht (53) und der Diffusionsunterdrückungszone (55) über die Pufferschicht (39) eingeleitet werden, und daß die i-Basiszone (52) und die Emitterzone (54) durch Diffusion von Verunreinigungen von der polykristallinen Siliziumschicht (45) über die Öffnung in der Isolationsschicht (37) gebildet werden, die die Basiskontaktelektrodenschicht (36) bedeckt, wobei die polykristalline Siliziumschicht (45) auf einer Seitenwand (44) gebildet wird, die auf der seitlichen Seite der Öffnung in der Basiskontaktelektrodenschicht (36) und der Isolationsschicht (37) gebildet wird.

2. Verfahren nach Anspruch 1, wobei das Halbleitersubstrat (31, 32, 34) des ersten Leitfähigkeits-Typus durch Bereitstellen einer vergrabenen Schicht (32) des ersten Leitfähigkeits-Typus auf einem Siliziumsubstrat (31) des zweiten Leitfähigkeits-Typus gebildet wird und eine Epitaxialschicht (34) des ersten Leitfähigkeits-Typus auf der vergrabenen Schicht (32) gebildet wird.

3. Verfahren nach Anspruch 2, wobei die Tiefe des Übergangs zwischen der i-Basiszone (52) und der Epitaxialschicht (34) eine Spitzenkonzentration von Verunreinigungen in der Diffusionsunterdrückungszone (55) aufweist.

## Revendications

1. Procédé de production d'un transistor bipolaire, le procédé comprenant les opérations suivantes :
former sélectivement une région (35) d'isolation de dispositif à la surface d'un substrat semiconducteur (31, 32, 34) ayant un premier type de conductivité ;
former une couche d'électrode de contact de base (36) recouverte par une pellicule isolante (37) qui s'étend sur une région de la surface du substrat semiconducteur (31, 32, 34) et est entourée au moins par la région d'isolation de dispositif (35) ;
introduire, en utilisant la couche d'électrode de contact de base (36) comme partie d'un masque, des impuretés du deuxième type de conductivité à travers une ouverture ménagée dans la pellicule isolante (37) et la couche d'électrode de contact de base (36), afin de former une couche de diffusion d'impuretés de liaison (53) à la surface dudit substrat semiconducteur (31, 32, 34) ;
introduire par l'ouverture de la pellicule isolante (37) et de la couche d'électrode de contact de base (36) des impuretés du premier type de conductivité afin de former une région de suppression de diffusion (55) à la partie inférieure d'une région dans laquelle une région de base doit être formée ;
former une région de base de greffe (51) à la surface dudit substrat semiconducteur (31, 32, 34) par diffusion d'impuretés du deuxième type à partir de la couche d'électrode de contact de base (36) ;
former une région de base intrinsèque (52) contiguë à ladite région de diffusion d'impuretés de liaison (53) à la surface dudit substrat semiconducteur (31, 32, 34) ; et
former une région d'émetteur (54) dans ladite région de base intrinsèque (52) ;
caractérisé en ce qu'une pellicule tampon (39) est formée sur l'ouverture ménagée dans la couche d'électrode de contact de base (36), les impuretés destinées à former la couche de diffusion d'impuretés de liaison (53) et la région de suppression de diffusion (55) étant introduites à travers la pellicule tampon (39), et en ce que la région de base intrinsèque (52) et la région d'émetteur (54) sont formées par diffusion d'impuretés à partir d'une couche de silicium polycristallin (45) à travers l'ouverture de la pellicule isolante (37) couvrant la couche d'électrode de contact de base (36), la couche de silicium polycristallin (45) étant formée sur une paroi latérale (44) qui est formée sur le côté latéral de l'ouverture de la couche d'électrode de contact de base (36) et de la pellicule isolante (37).

2. Procédé selon la revendication 1, où on forme le substrat semiconducteur (31, 32, 34) du premier type de conductivité en produisant une couche enterrée (32) du premier type de conductivité sur un substrat de silicium (31) du deuxième type de conductivité et on forme une couche épitaxiale (34) du premier type de conductivité sur la couche enterrée (32).

3. Procédé selon la revendication 2, où la profondeur de jonction entre la région de base intrinsèque (52) et la couche épitaxiale (34) possède une crête de concentration d'impuretés dans la région de suppression de diffusion (55).
